# EUROPEAN PATENT SPECIFICATION

(11) **EP 2 297 223 B1**
(45) Date of publication and mention of the grant of the patent: **13.11.2013**
(21) Application number: 09772455.3
(22) Date of filing: 30.06.2009
(51) Int. Cl.: C08G 61/12, C09K 11/06, H01B 1/12, H01L 51/00, H01L 51/05, H01L 51/42, H01L 51/50, H05B 33/14

(54) **HIGH PERFORMANCE SOLUTION PROCESSABLE SEMICONDUCTING POLYMERS BASED ON ALTERNAT-ING DONOR ACCEPTOR COPOLYMERS**
IN EINER LÖSUNG VERARBEITBARE HOCHLEISTUNGSHALBLEITERPOLYMERE AUF DER BASIS VON ALTERNIERENDEN DONOR-AKZEPTOR-COPOLYMEREN
POLYMÈRES SEMI-CONDUCTEURS TRANSFORMABLES EN SOLUTION À HAUTE PERFORMANCE À BASE DE COPOLYMÈRES ALTERNATIVEMENT DONNEURS ET ACCEPTEURS

(30) Priority: 02.07.2008 EP 08159534
(43) Date of publication of application: 23.03.2011
(73) Proprietor: BASF SE, 67056 Ludwigshafen (DE); Max-Planck-Gesellschaft zur Förderung der Wissenschaften e.V., 80539 München (DE)
(72) Inventor: KASTLER, Marcel, 4056 Basel (CH); KÖHLER, Silke, 4056 Basel (DE); MÜLLEN, Klaus, 50939 Köln (DE); TSAO, Hoi Nok, 55124 Mainz (DE); CHO, Don, 55127 Mainz (DE)
(86) International application number: PCT/EP2009/058218
(87) International publication number: WO 2010/000755

(56) References cited:
- US-A1- 2007 014 939
- MING ZHANG ET AL.: "Field-Effect Transistors Based on a Benzothiadiazole-Cyclopentadithiophene Copolymer" JOURNAL OF THE AMERICAN CHEMICAL SOCIETY, vol. 129, no. 12, 7 March 2007 (2007-03-07), pages 3472-3473, XP002541044 US cited in the application
- "Influence of the Molecular Weight of Poly(3-hexylthiophene) on the Performance of Bulk Heterojunction Solar Cells" CHEMISTRY OF MATERIALS, vol. 17, no. 8, 23 March 2005 (2005-03-23), pages 2175-2180, XP002541042
- ADAM J. MOULÉ ET AL.: "Two Novel Cyclopentadithiophene-Based Alternating Copolymers as Potential Donor Components for High-Efficiency Bulk-Heterojunction-Type Solar Cells" CHEMISTRY OF MATERIALS, vol. 20, no. 12, 21 May 2008 (2008-05-21), pages 4045-4050, XP002541043 ACS, WASHINGTON, DC, US
- JEAN-MARIE VERILHAC ET AL.: "Molecular weight dependent charge carrier mobility in poly(3,3''-dioctyl-2,2':5',2''-terthiophen e)" THE JOURNAL OF PHYSICAL CHEMISTRY B, vol. 110, no. 27, 10 June 2006 (2006-06-10), pages 13305-13309, XP002541069
- PAOLO COPPO ET AL.: "Synthetic Routes to Solution-Processable Polycyclopentadithiophenes" MACROMOLECULES, vol. 36, no. 8, 28 March 2003 (2003-03-28), pages 2705-2711, XP002541041 ACS, WASHINGTON, DC, US cited in the application

## Description

The present invention relates to benzothiadiazole-cyclopentadithiophene copolymers, to a process for their preparation and to their use as semiconductors or charge transport materials.

The formidable building block for the development of (micro)electronics during the last one-half of the 20^{th} century is the field-effect transistor (FET) based on inorganic electrodes, insulators, and semiconductors. These materials have proven to be reliable, highly efficient, and with performance that increases periodically according to the well-known Moore's law. Rather than competing with conventional silicon technologies, an organic FET (OFET) based on molecular and polymeric materials may find large scale applications in low-performance memory elements as well as integrated optoelectronic devices, such as pixel drive and switching elements in active-matrix organic light-emitting diode displays, RFID tags, smart-ID tags, and sensors.

As a result of the development of several conductive or semiconductive organic polymers, the application of those as active layer, thus the semiconductor, in organic thin-film transistors (OTFTs) has gained increasing attention.

The use of organic semiconductors in OTFTs has some advantages over the inorganic semiconductors used to date. They can be processed in any form, from the fiber to the film, exhibit a high mechanical flexibility, can be produced at low cost and have a low weight. The significant advantage is, however, the possibility of producing the entire semiconductor component by deposition of the layers from solution on a polymer substrate at atmospheric pressure, for example by printing techniques, such that inexpensively producible FETs are obtained.

The performance of the electronic devices depends essentially on the mobility of the charge carriers in the semiconductor material and the ratio between the current in the on-state and the off-state (on/off ratio). An ideal semiconductor therefore has a minimum conductivity in the switched-off state and a maximum charge carrier mobility in the switched-on state (mobility above 10⁻³ cm²V⁻¹s⁻¹ on/off ratio above 10²). In addition, the semiconductor material has to be relatively stable to oxidation, i.e. has to have a sufficiently high ionization potential, since its oxidative degradation reduces the performance of the component.

EP 1510535 A1 describes polythieno(2,3-b)thiophenes, which have a mobility of 3·10⁻³ or 1.7 · 10⁻² cm²V⁻¹s⁻¹ and on/off ratios of about 10⁶. WO2006/094645 A1 describes polymers, which have one or more selenophene-2,5-diyl and one or more thiophene-2,5-diyl groups, while WO 2006/131185 discloses polythieno(3,4-d)thiazoles, and US 2005/0082525 A1 discloses benzo(1,2-b,4,5-b')dithiophenes.

US 2007/0014939 discloses copolymers of cyclopentadithiophene substituted with C₁-C₂₀ alkyl and benzothiadiazole as semiconducting material. In the examples, copolymers of cyclopentadithiophene disubstituted with n-hexyl and ethylhexyl, respectively, are prepared. The materials suffer from only moderate charge carrier mobilities (in the range of 10⁻³ cm²/Vs).

Z. Zhu et al., Macromolecules 2007, 40 (6), 1981-1986, disclose copolymers of cyclopen-tadithiophene disubstituted with *n*-hexyl and 2-ethylhexyl substituents, respectively, and benzothiadiazole. For field effect transistors made of this material, a hole mobility of 0.015 cm²/Vs is reported.

Zhang et al., J. Am. Chem. Soc. 2007, 129(12), 3472-3473 disclose copolymers of cyclopentadithiophene disubstituted with *n*-hexadecyl or 3,7-dimethyloctyl substituents, respectively, and benzothiadiazole with a number-average molecular weight of 10.2 kg/mol exhibiting a charge carrier mobility of 0.17 cm²/Vs in a FET.

It is an object of the present invention to provide novel compounds for use as organic semiconductor materials, which are easy to synthesize, have high mobilities and a good oxidation stability, and can be processed readily.

This object is achieved by a benzothiadiazol-cyclopentadithiophene copolymer comprising as repeating units the group of the formula (I) 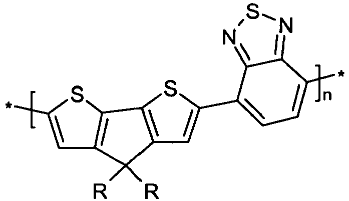 wherein R is *n*-hexadecyl or 3,7-dimethyloctyl ,
and having a number average molecular weight Mₙ in the range of from 30 to 70 kg/mol.

The advantage of the benzothiadiazol-cyclopentadithiophene copolymer of the present invention is a significantly increased charge carrier mobility in a field effect transistor due to an improved, higher molecular weight in combination with a high purity of the material. The number average molecular weight Mₙ is preferably in the range of from 40 to 60 kg/mol. In one particular embodiment, Mₙ is in the range of from 65 to 70 kg/mol.

R is *n*-hexadecyl or 3,7-dimethyloctyl .

"Mobility" or "mobility" refers to a measure of the velocity with which charge carriers induced by an external stimulus such as an electric field, for example, holes (or units of positive charge) in the case of a p-type semiconducting material and electrons in the case of an n-type semiconducting material, move through the material under the influence of an electric field.

The present invention further provides for the use of the copolymers according to the present invention as semiconductors or charge transport materials, especially in optical, electrooptical or electronic components, as thin-film transistors, especially in flat visual display units, or for radiofrequency identification tags (RFID tags) or in semiconductor components for organic light-emitting diodes (OLEDs), such as electroluminescent displays or backlighting for liquid-crystalline displays, for photovoltaic components or in sensors, as electrode material in batteries, as optical waveguides, for electrophotography applications such as electrophotographic recording.

The present invention further provides optical, electrooptical or electronic components comprising the polymer according to the present invention. Such components may be, for example, FETs, integrated circuits (ICs), TFTs, OLEDs or alignment layers.

The polymers according to the present invention are suitable particularly as semiconductors, since they show high mobilities required for this purpose.

The polymers may be end-capped by several groups as known from the prior art. Preferred end groups are H, substituted or unsubstituted phenyl or substituted or unsubstituted thiophene, without being restricted thereto.

The copolymers according to the present invention can be prepared by methods which are already known. Preferred synthesis routes are described hereinafter.

The copolymers of the invention can preferably be prepared from 2,1,3-benzothiadiazole-4,7-bis(4,4,5,5-tetramethyl-1,3,2-dioxaborolan-2-yl) (BTZ) and 2,6-dibromo-4,4-dihexadecyl-4H-cyclopenta[2,1-b:3,4-b']dithiophene (CDT).

The monomer 2,6-dibromo-4,4-dihexadecyl-4H-cyclopenta[2,1-b:3,4-b']dithiophene (CDT) can be prepared by the method described in P. Coppo et al., Macromolecules 2003, 36, 2705 - 2711, using the following reaction scheme:

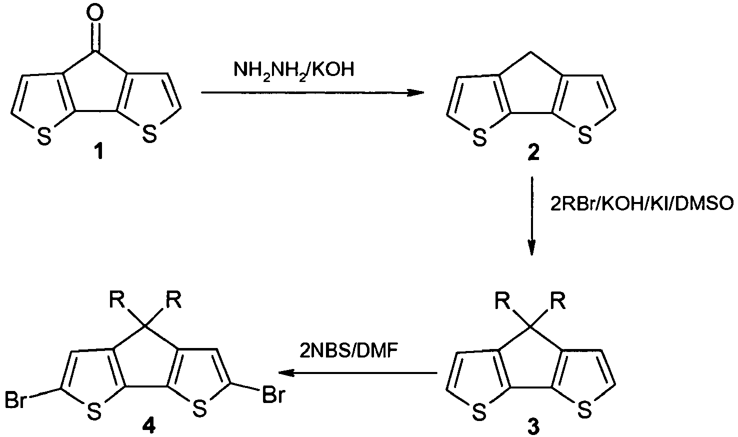

In this scheme, R is *n*-hexadecyl or 3,7-dimethyloctyl.

The comonomer 2,1,3-benzothiadiazole-4,7-bis(4,4,5,5-tetramethyl-1,3,2-dioxaborolan-2-yl) (BTZ) can be prepared from 4,7-dibromo-2,1,3-benzothiadiazole as described in Zhang et al., J. Am. Chem. Soc. 2007, 129(12), 3472-3473.

The BTZ/CDT copolymer can be synthesized via a cross-coupling polymerisation reaction, such as Stille or Suzuki reaction, in which an aryl dihalide is reacted with an organotin compound or a boronic diester/acid in the presence of a base and a small amount of metal catalyst such as tetrakis(triphenylphosphino)palladium(0). Typically the reaction is carried out in a solvent or mixture of solvents with a reaction temperature between 20°C and 130°C.

Essential for the synthesis of high molecular weight polymer is the utilisation of the Suzuki cross-coupling reaction together with high purity monomers having a purity of > 99% and therefore an appropriate purification method of the utilized monomers is needed.

The BTZ monomer which was previously obtained as a pink solid (Zhang et al., J. Am. Chem. Soc. 2007, 129(12), 3472-3473) is subjected to multiple recrystallizations to yield colourless crystals with a purity >99% determined by GC.

In order to obtain CDT in the required purity of > 99%, a recycling GPC can be used.

The molecular weight can be reproducibly obtained by adjusting the concentration of the 1:1 monomer mixture. The optimum, total concentration of the monomers in the reaction solution to yield a number average molecular weight of 50-60 kg/mol is about 60 wt%.

The invention comprises both the oxidized and the reduced forms of the polymers according to the present invention. Either a deficiency or an excess of electrons leads to the formation of a delocalized ion which has a high conductivity. This can be done by doping with customary dopants. Dopants and doping processes are common knowledge and are known, for example, from EP-A 0 528 662, US 5198153 or WO 96/21659. Suitable doping processes comprise, for example, doping with a doping gas, electrochemical doping in a solution comprising the dopant, by thermal diffusion and by ion implantation of the dopant into the semiconductor material.

In the case of use of electrons as charge carriers, preference is given to using halogens (e.g. I₂, Cl₂, Br₂, ICl, ICl₃, IBr and IF), Lewis acids (e.g. PF₅, AsF₅, SbF₅, BF₃, BCl₃, SbCl₅, BBr₃ and SO₃), inorganic acids (e.g. HF, HCl, HNO₃, H₂SO₄, HClO₄, FSO₃H and ClSO₃H), organic acids or amino acids, transition metal compounds (e.g. FeCl₃, FeOCl, Fe(ClO₄)₃ Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (where Ln is a lanthanoid)), anions (e.g. Cl⁻, Br⁻, I⁻, I₃⁻, HSO₄⁻, SO₄²⁻, NO₃⁻, ClO₄⁻, BF₄⁻, PF₆⁻, AsF₆⁻, SbF₆⁻, FeCl₄⁻, Fe(CN)₆³⁻, and anions of different sulfonic acids such as aryl-SO₃⁻). In the case of use of holes as charge carriers, as dopants, for example, are cations (e.g. H⁺, Li⁺, Na⁺, K⁺, Rb⁺ and Cs⁺), alkali metals (e.g. Li, Na, K, Rb, and Cs), alkaline earth metals (e.g. Ca, Sr and Ba), O₂, XeOF₄, (NO₂⁺) (SbF₆⁻), (NO₂⁺) (SbCl₆⁻), (NO₂⁺) (BF₄⁻), AgClO₄, H₂IrCl₆, La(NO₃)₃, FSO₂OOSO₂F, Eu, acetylcholine, R₄N⁺, R₄P⁺, R₆As⁺ and R₃S⁺, where R is an alkyl group.

The conductive form of the copolymers according to the present invention can be used as an organic conductor, for example charge injection layers and ITO planarizing layers in organic light-emitting diodes (OLEDs), flat screens and touch screens, antistatic films, printed circuits and capacitors, without being restricted thereto.

The copolymers according to the present invention can be used to produce optical, electronic and semiconductor materials, especially as charge transport materials in field-effect transistors (FETs), for example as components of integrated circuits (ICs), ID tags or TFTs. Alternatively, they can be used in organic light-emitting diodes (OLEDs) in electroluminescent displays or as backlighting, for example liquid-crystal displays (LCDs), in photovoltaic applications or for sensors, for electrophotographic recording and other semiconductor applications.

Since the copolymers according to the present invention have good solubility, they can be applied to the substrates as solutions. Layers can therefore be applied with inexpensive processes, for example spin-coating or printing.

Suitable solvents or solvent mixtures comprise, for example, ether, aromatics and especially chlorinated solvents.

FETs and other components comprising semiconductor materials, for example diodes, can be used advantageously in ID tags or security labels in order to indicate authenticity and to prevent forgeries of valuable items such as banknotes, credit cards, identity documents such as ID cards or driving licenses or other documents with pecuniary advantage such as rubber stamps, postage stamps or tickets, etc.

Alternatively, the polymers according to the present invention can be used in organic light-emitting diodes (OLEDs), for example in displays or as backlighting for liquid-crystal displays (LCDs). Typically, OLEDs have a multilayer structure. A light-emitting layer is generally embedded between one or more electron- and/or hole-transporting layers. When an electrical voltage is applied, the electrons or holes can migrate in the direction of the emitting layer, where their recombination to the excitation and subsequent luminescence of the luminophoric compounds in the emitting layer. The polymers, materials and layers may, according to their electrical and optical properties, find use in one or more of the transport layers and/or emitting layers. When the compounds, materials or layers are electroluminescent or have electroluminescent groups or compounds, they are particularly suitable for the emitting layer.

Like the processing of suitable polymers for use in OLEDs, the selection is common knowledge and is described, for example, in Synthetic Materials, 111-112 (2000), 31-34 or J. Appl. Phys., 88 (2000) 7124-7128.

All quantitative data (percentages, ppm, etc.) are based on the weight, based on the total weight of the mixture, unless stated otherwise.

### Examples

The monomers 2,1,3-benzothiadiazole-4,7-bis(4,4,5,5-tetramethyl-1,3,2-dioxaborolan-2-yl) (BTZ) and 2,6-dibromo-4,4-dihexadecyl-4H-cyclopenta[2,1-b:3,4-b']dithiophene (CDT) were synthesized following published procedures (Zhang et al., J. Am. Chem. Soc. 2007, 129(12), 3472-3473; P. Coppo et al., Macromolecules 2003, 36, 2705 - 2711)

### Example 1

### Synthesis of the Diboronic ester BTZ

A solution of 4,7-dibromo-2,1,3-benzothiadiazole (1 g, 3.41 mmol), bis(pinacolato)diboron (2 g, 7.8 mmol), PdCl₂(dppf) (500 mg, 0.6 mmol), and KOAc (2 g, 20 mmol) in degassed 1,4-dioxane (10 ml) was stirred at 80 °C overnight. The reaction was quenched by adding water, and the resulting mixture was washed with ethyl acetate (30 ml × 3). The organic layers were washed with brine, dried over Na₂SO₄, and concentrated in vacuo to yield a dark red solid. The solid was purified by silica gel chromatography by 3 % ethyl acetate in hexane to give the desired compound as a pink solid. The crude product was recrystallized four times from ethanol, yielding colorless crystals, resulting in 300 mg of BTZ.

FD-MS: m/z = 388.0 (calcd. 388.1). ¹H NMR (250 MHz, CD₂Cl₂): δ 8.10 (s, 2H), 1.41 (s, 24H). ¹³C NMR (62.9 MHz, CD₂Cl₂): δ 157.55, 138.11, 84.91, 25.3.

### Example 2

### Synthesis of 4,4-di-n-hexadecyl-cyclopenta[2,1-b:3,4-b']dithiophene / 4,4-bis-(3,7-dimethyloctyl)-cyclopenta[2,1-b:3,4-b']dithiophene

*4H*-Cyclopenta[2,1-b:3,4-b']dithiophene (2.0g, 11.2 mmol) was solublized in 50 mL of dimethyl sulfoxide. *n*-Hexadecylbromide or 2,7-dimethyloctylbromide, respectively, (22.4 mmol) was added, followed by potassium iodide (50 mg). The mixture was flushed with nitrogen and cooled in an ice bath, and finally ground potassium hydroxide (2.0 g) was added in portions. The resulting green mixture was vigorously stirred over night at room temperature. The reaction vessel was then cooled in an ice bath, and water (50 mL) was added. The organic phase was extracted twice with diethyl ether, washed with water, brine and ammonium chloride solution, and dried with magnesium sulphate. The evaporation of the solvent afforded the title compound as a yellow oil. Purification by chromatography over silica/hexanes was performed to eliminate traces of monoalkylated product and unreacted alkylbromide. The title compound was obtained as a clear oil. Yield: 85%

### Example 3

### Synthesis of 2,6-dibromo-4,4-di-n-hexadecyl-cyclopenta[2,1-b:3,4-b']dithiophene / 2,6-dibromo-4,4-bis(3,7-dimethyloctyl)-cyclopenta[2,1-b:3,4-b']dithiophene

4,4-di-n-hexadecyl-cyclopenta[2,1-b:3,4-b']dithiophene / 4,4-bis-(3,7-dimethyloctyl)-cyclopenta[2,1-b:3,4-b']dithiophene (4,97 mmol) was solubilised in 50 mL of distilled DMF under nitrogen in the dark. NBS (1.8 g, 9,94 mmol) was added portionwise. The resulting yellow solution was stirred at room temperature under nitrogen over night. Water (50 mL) was then added, and the organic phase was extracted with diethyl ether (100 mL) twice, washed with water and with 1% HCl solution and dried with magnesium sulphate. The solvent was removed under reduced pressure to obtain the title product as a yellow oil. Impurities were removed by column chromatography over silica/hexane and recycling GPC (4-5 times). The title compound was obtained as a colorless oil (yield 68%).

### Example 4

### Synthesis and Purification of the Polymers:

The BTZ/*n*-hexadecyl-CDT copolymer was synthesized via a Suzuki coupling reaction. *n-*hexadecyl-CDT (300 mg, 0.382 mmol) and BTZ (148 mg, 0.382 mmol), K₂CO₃ (2mL, 2M) and 3 drops of Aliquat 336 were dissolved into X mL of toluene in a 50 mL Schlenk flask equipped with a reflux condenser. The solution was then degassed using the freeze/pump/purge method three times, and tetrakis(triphenylphosphine)palladium was added. The solution was then freeze/pump/purged an additional three times and heated to 100 °C for three days. Then 0.1 mL of a 1 M solution of phenyl boronate ester in toluene was added and stirred an additional 12 hours, at which time 0.1 mL of a 1 M solution of bromobenzene in toluene was added in order to end cap the reactive chain ends.

The resulting mixture was poured into a mixture of methanol and concentrated hydrochloric acid (2:1) and stirred overnight. The solid was filtered and dissolved into hot chlorobenzene, then precipitated from methanol and subjected to soxhlet extraction with acetone. The polymer was subsequently precipitated three times from hexane, acetone, and ethyl acetate, followed by soxhlet extraction with hexane to yield 190 mg (43%). GPC analysis: Mₙ = 5k (X = 10mL); 14k (X = 8mL); 51 k (X = 4mL), D = 2.6-4.0.

The BTZ/3,7-dimethyloctyl-CDT was obtained analogously yielding a number-average molecular weight of 38k, D = 4.5 using X = 4mL of toluene.

Molecular weights of the polymers were determined by gel permeation chromatography (GPC) against polystyrene standards using trichlorobenzene as an eluent. Samples were passed through three columns, first one with a porosity range at 10⁶, the second at 10⁴, and the last at 500.

### Example 5

### FET device preparation and measurement

Highly n++ doped Si wafer with a 150 nm SiO₂ layer was used as transistor substrates. The SiO₂ dielectric was treated with phenyltriethoxysilane. The whole substrate was then immersed in a solution containing 1 mg/ml copolymer (dissolved in chlorobenzene). By slowly taking the sample out at a rate of 1 µm/s, a polymer film was "directionally grown" via this dip-coating method. Alternatively the semiconducting layer can be coated by spincoating a 0.5 wt% solution in chlorobenzene with a thickness of 50 nm. This polymer layer was heated at 200°C for 1 h in nitrogen atmosphere and the transistors were finished by evaporating 50 nm gold contacts on top of this layer.

The charge carrier mobilities were derived from the saturation transfer plot.

### FET characteristics:

The charge carrier mobility determined in a field effect transistor shows clearly a dependence upon the molecular weight in favour of higher molecular weights (Table 1)

**Table 1: Transistor performance for BTZ/n-hexadecyl-CDT copolymer in dependence of molecular weight obtained by spin coating:**

| Molecular Weight Mₙ (g/mol) | Mobility (cm²/Vs) | Iₒₙ/I_{off} |
|---|---|---|
| 5K | 0.06 | 10³ |
| 14K | 0.17 | 10⁵ |
| 51K | 0.57 | 10³ |

| | | |
|---|---|---|
| For spin-coating of the polymer with Mₙ of 51 k, the FETs show hole mobilities of 0.65 cm²/Vs and a current on/off ratio of Iₒₙ/I_{off} = 10³ when measured in nitrogen. | | |

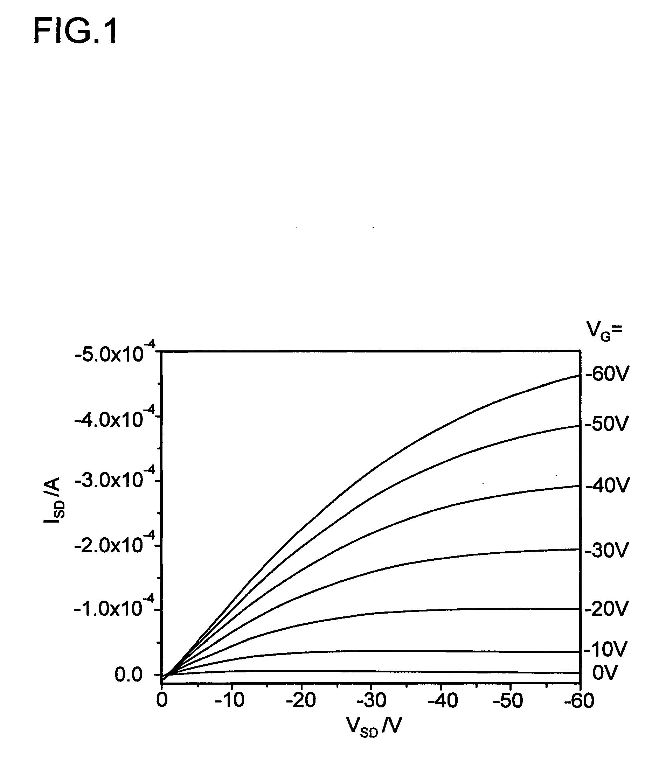

For dip coating of the polymer, the FETs show hole mobilities of 1.4 cm²/Vs and a current on/off ratio of Iₒₙ / I_{off} = 10⁵ when measured in nitrogen. Typical output curves at various gate voltages V_{G} are illustrated in Figure 1.

The BTZ/3,7-dimethyloctyl-CDT copolymer shows a charge carrier mobility of 0.45 cm²/Vs and a current on/off ratio of Iₒₙ/ I_{off} = 10⁵ when measured in nitrogen.

### Example 6

BTZ (148 mg, 0.382 mmol), *n*-hexadecyl-CDT (300 mg, 0.382 mmol) and K₂CO₃ (12 eq, 4.584 mmol in a 2 M solution) and 3 drops of Aliquat 336 were dissolved into 4 mL of toluene in 25 mL Schlenk flask equipped with a reflux condenser. The solution was then degassed using the freeze/pump/purge method three times, and tetrakis(triphenylprosphine)palladium (0.0191 mmol) was added under argon. The solution was then freeze/pump/purged an additional three times and heated to 100°C under argon for 24 hours. The reaction was then cooled to room temperature and an additional 4 mL of toluene was added. The mixture was degassed three times using the freeze/pump/purge method and additional tetrakis(triphenylprosphine)palladium (0.0191 mmol) was added, followed by 3 freeze/pump/purge cycles. The reaction was heated to 100°C for 48 hours, and then a solution of phenyl boronate ester (0.1 M) in toluene was added and stirred an additional 12 hours, at which time a solution of bromobenzene (0.1 M) in toluene was added. The resulting mixture was poured into a mixture of methanol and concentrated hydrochloric acid (2:1) and stirred for 4 hours. The solid was filtered and dissolved into hot 1,2,4-trichlorobenzene, then precipitated from methanol and subjected to soxhlet extraction with acetone. The polymer was subsequently precipitated three times from hexane, acetone, and ethyl acetate, followed by soxhlet exraction with hexae to yield 200 mg (45%).

GPC analysis: Due to limited solubility, a direct comparison of molecular weight of this sample could not be made. However, GPC analysis in a single column with trichlorbenzene at 130°C as eluent, when compared with the sample with an Mₙ measured at 5.1 x 10⁴ shows an increase of ~35%, giving an extrapolated value of Mₙ = 6.9 X 10^{4.}

### FET device preparation and measurement

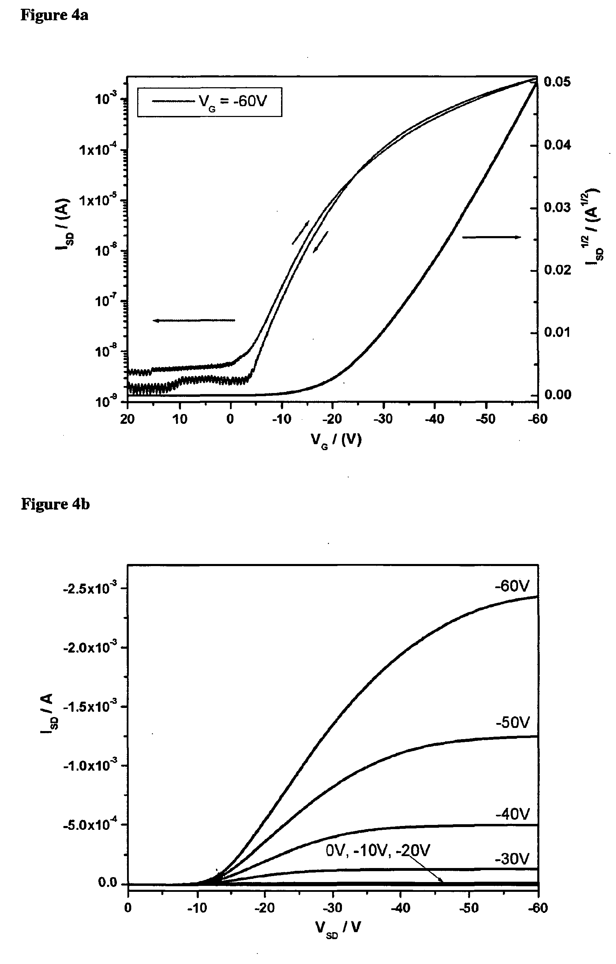

Samples were drop-cast from 2 mg/mL in o-Dichlorobenzene on bottom contact FET substrates held at 100°C with 200 nm SiO₂ functionalized with HMDS. The channel lengths and widths are 20 µm and 1.4 mm respectively. Four transistors were measured with the lowse saturated hole mobility of µₛₐₜ = 2.5 cm²/Vs and the highest being µₛₐₜ = 3.3 cm²/Vs. The average mobility is µ_{sat =} 2.95 cm²/VS. The on/off ration is 10⁶ (Figure 4). Processing was conducted in nitrogen atmosphere.
Figure 1 shows a typical output characteristic for spincoated BTZ/n-hexadecyl-CDT copolymer (Mₙ = 51 K).

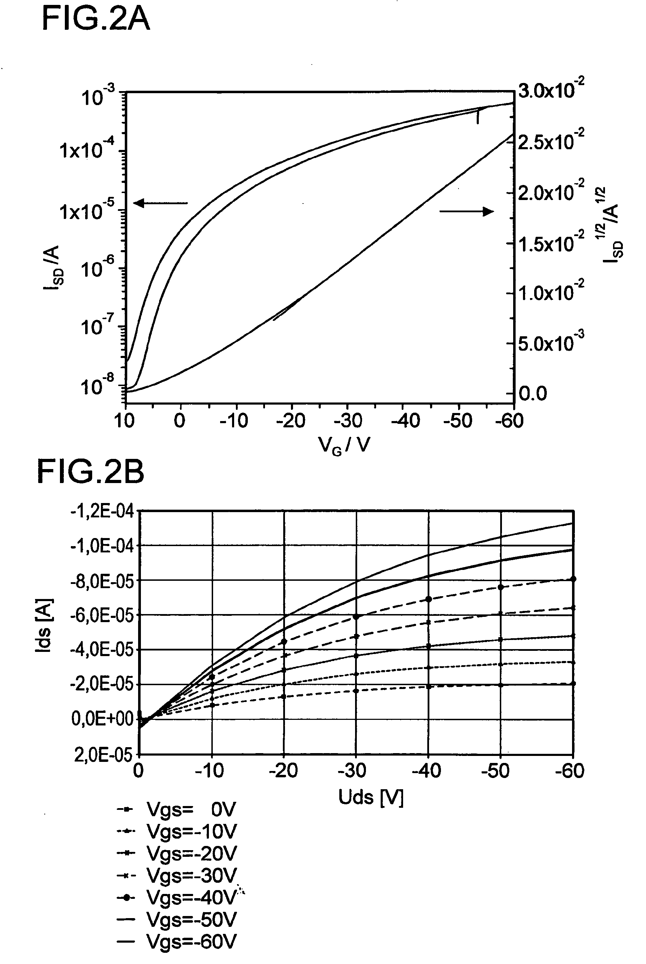

Figures 2a and b show a typical transfer (a) and output (b) characteristic for spincoated BTZ/3,7-dimethyloctyl-CDT copolymer (Mₙ = 38K).

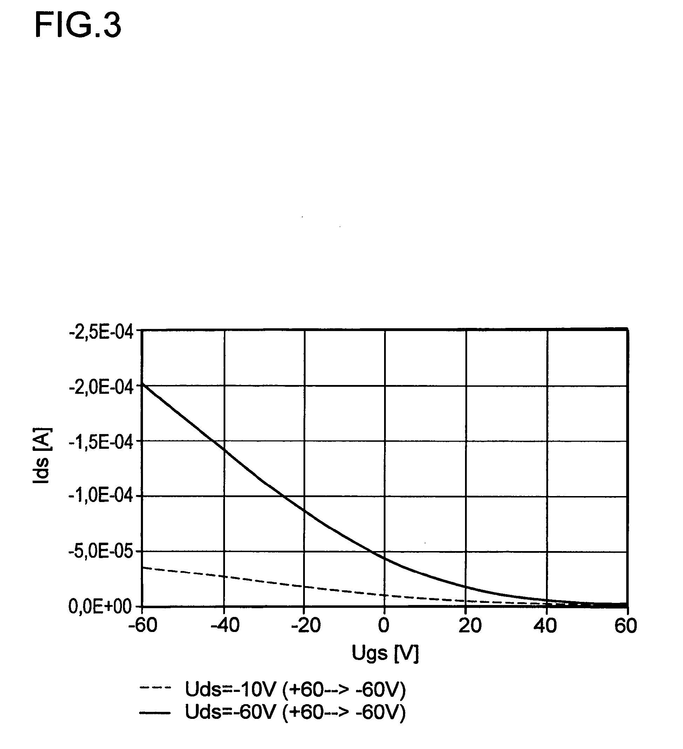

Figure 3 shows a typical transfer characteristic for dip coated BTZ/n-hexadecyl-CDT copolymer (Mₙ = 51 K).
Figures 4a and b show a typical transfer (a) and output (b) characteristic for n-hexadecyl-CDT copolymer (Mₙ = 69K).

## Claims

1. A benzothiadiazol-cyclopentadithiophene copolymer comprising as repeating unit the group of the formula (I) 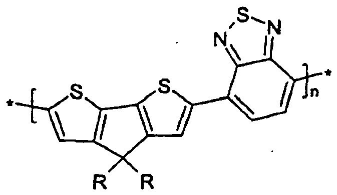 wherein R is n-hexadecyl or 3,7-dimethyloctyl,
and having a number average molecular weight Mₙ in the range of from 30 to 70 kg/mol, as determined by gel permeation chromatography against polystyrene standards using trichlorobenzene as an eluent.

2. The use of the copolymers according to claim 1 as semiconductors or charge transport materials, as thin-film transistors (TFTs), or in semiconductor components for organic light-emitting diodes (OLEDs), for photovoltaic components or in sensors, as an electrode material in batteries, as optical waveguides or for electrophotography applications.

3. A composition comprising one or more polymers of claim 1 dissolved or dispersed in a liquid medium.

4. A thin film semiconductor comprising one or more copolymers of claim 1.

5. A composite comprising a substrate and the thin film semiconductor of claim 4 deposited on the substrate.

6. A process for preparation of a composite according to claim 5 comprising dissolving the copolymer according to claim 1 in a liquid medium to form a solution, depositing the solution on a substrate, and removing the solvent to form a thin film semiconductor on the substrate.

7. The process according to claim 6, wherein the solution is deposited by spin coating, dip coating or printing.

8. A field effect transistor device comprising the thin film semiconductor of claim 4 or the composite of claim 5.

9. A photovoltaic device comprising the thin film semiconductor of claim 4 or the composite of claim 5.

10. An organic light emitting diode device comprising the thin film semiconductor of claim 4 or the composite of claim 5.

## Patentansprüche

1. Benzothiadiazolcyclopentadithiophen-Copolymer, das als Wiederholungseinheit die Gruppe der Formel (I) 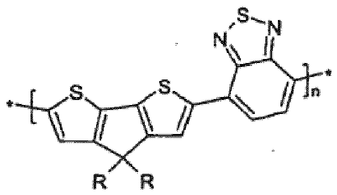 wobei R n-Hexadecyl oder 3,7-Dimethyloctyl ist, umfasst
und ein zahlendurchschnittliches Molekulargewicht Mₙ im Bereich von 30 bis 70 kg/Mol, wie durch Gelpermeationschromatographie gegen Polystyrolstandards unter Anwendung von Trichlorbenzol als Elutionsmittel bestimmt, aufweist.

2. Verwendung der Copolymere nach Anspruch 1 als Halbleiter oder Ladungsübertragungsmaterialien, als Dünnschichttransistoren (TFT) oder in Halbleiterkomponenten für organische lichtemittierende Dioden (OLED), für photovoltaische Komponenten oder in Sensoren, als ein Elektrodenmaterial in Batterien, als optische Wellenleiter oder für elektrophotographische Anwendungen.

3. Zusammensetzung, umfassend ein oder mehrere Polymere nach Anspruch 1, in einem flüssigen Medium gelöst oder dispergiert.

4. Dünnschichthalbleiter, umfassend ein oder mehrere Copolymere nach Anspruch 1.

5. Verbundstoff, umfassend ein Substrat und den auf dem Substrat abgesetzten Dünnschichthalbleiter nach Anspruch 4.

6. Verfahren zur Herstellung eines Verbundstoffs nach Anspruch 5, umfassend das Lösen des Copolymers nach Anspruch 1 in einem flüssigen Medium unter Bildung einer Lösung, das Absetzen der Lösung auf einem Substrat und das Entfernen des Lösungsmittels unter Bildung eines Dünnschichthalbleiters auf dem Substrat.

7. Verfahren nach Anspruch 6, wobei die Lösung durch Schleuderbeschichten, Tauchbeschichten oder Drucken abgesetzt wird.

8. Feldeffekttransistorvorrichtung, umfassend den Dünnschichthalbleiter nach Anspruch 4 oder den Verbundstoff nach Anspruch 5.

9. Photovoltaische Vorrichtung, umfassend den Dünnschichthalbleiter nach Anspruch 4 oder den Verbundstoff nach Anspruch 5.

10. Organische lichtemittierende Diodenvorrichtung, umfassend den Dünnschichthalbleiter nach Anspruch 4 oder den Verbundstoff nach Anspruch 5.

## Revendications

1. Copolymère benzothiadiazole-cyclopentadithiophène comprenant comme motif répétitif le groupe de formule (I) 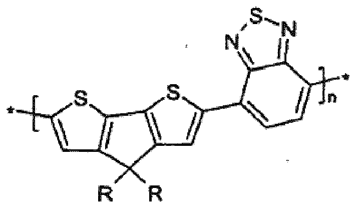 dans laquelle R représente un radical n-hexadécyle ou 3,7-diméthyloctyle,
et ayant un poids moléculaire moyen en nombre Mₙ dans la gamme de 30 à 70 kg/mol, tel que déterminé par chromatographie par perméation de gel par rapport à des étalons de polystyrène en utilisant du trichlorobenzène comme éluant.

2. Utilisation des copolymères selon la revendication 1 comme semi-conducteurs ou matériaux de transport de charges, comme transistors en couches minces (TFT), ou dans des composants semi-conducteurs pour diodes électroluminescentes organiques (DELO), pour composants photovoltaïques ou dans des capteurs, comme un matériau d'électrode dans des batteries, comme guides d'ondes optiques ou pour des applications électrophotographiques.

3. Composition comprenant un ou plusieurs polymères de la revendication 1 dissous ou dispersés dans un milieu liquide.

4. Semi-conducteur en couche mince comprenant un ou plusieurs copolymères de la revendication 1.

5. Composite comprenant un substrat et le semi-conducteur en couche mince de la revendication 4 déposé sur le substrat.

6. Procédé de préparation d'un composite selon la revendication 5 comprenant la dissolution du copolymère selon la revendication 1 dans un milieu liquide pour former une solution, le dépôt de la solution sur un substrat, et l'élimination du solvant pour former un semi-conducteur en couche mince sur le substrat.

7. Procédé selon la revendication 6, dans lequel la solution est déposée par dépôt à la tournette, revêtement au trempé ou impression.

8. Dispositif à transistors à effet de champ comprenant le semi-conducteur en couche mince de la revendication 4 ou le composite de la revendication 5.

9. Dispositif photovoltaïque comprenant le semi-conducteur en couche mince de la revendication 4 ou le composite de la revendication 5.

10. Dispositif à diodes électroluminescentes organiques comprenant le semi-conducteur en couche mince de la revendication 4 ou le composite de la revendication 5.
